(19) Europäisches Patentamt
European Patent Office
Office européen des brevets

(11) **EP 3 779 767 A1**

(12) **EUROPEAN PATENT APPLICATION**
published in accordance with Art. 153(4) EPC

(43) Date of publication:
**17.02.2021 Bulletin 2021/07**

(51) Int Cl.:
**G06K 9/00** (2006.01)

(21) Application number: **18903041.4**

(22) Date of filing: **27.12.2018**

(86) International application number:
**PCT/CN2018/124149**

(87) International publication number:
**WO 2019/192219 (10.10.2019 Gazette 2019/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.04.2018 CN 201810288463**

(71) Applicant: **BOE Technology Group Co., Ltd.
Beijing 100015 (CN)**

(72) Inventors:
• **TAN, Wenjing
Beijing 100176 (CN)**
• **SHI, Shiming
Beijing 100176 (CN)**

(74) Representative: **Gesthuysen Patentanwälte
Patentanwälte
Huyssenallee 100
45128 Essen (DE)**

(54) **PIXEL ARRAY AND DRIVING METHOD THEREFOR, AND DISPLAY APPARATUS**

(57) Embodiments of the present disclosure provide a pixel array, a driving method thereof, a display device comprising the pixel array. The pixel array is divided into at least one pixel distribution region, and comprises at least one standard pixel unit and at least one non-standard pixel unit distributed in the at least one pixel distribution region. Compared to the standard pixel unit, at least one sub-pixel is missing from the non-standard pixel unit, and the at least one sub-pixel that is missing is replaced by a sub-pixel missing region.

Fig.3

## Description

CROSS REFERENCE TO RELATED APPLICATIONS

The present application claims the benefit of Chinese Patent Application No. 201810288463.0, filed on April 3, 2018, the entire disclosure of which is incorporated herein by reference.

FIELD

The present disclosure relates to the field of display technologies. More specifically, the present disclosure relates to a pixel array, a driving method of the pixel array, and a display device comprising the pixel array.

BACKGROUND

Fingerprint recognition is a major method for identity authentication at present, which is widely used in fields such as security, smart attendance, especially mobile phones, and the like.

Currently, fingerprint recognition function has become a basic configuration of mobile phones. Existing fingerprint recognition schemes mainly include two types: back coating and off-screen fingerprint recognition. The former disposes a fingerprint recognition region on a back of a mobile phone or below a mobile phone screen, and obtains a fingerprint impression by a finger pressing the fingerprint recognition region. The latter places a fingerprint recognition chip under a glass cover plate of a mobile phone screen and performs fingerprint recognition by optical reflection, diffraction, image stitching and analysis, and the like.

The existing back-coating fingerprint recognition method would increase the time for fingerprint unlocking, which leads to an unfavorable user experience. In contrast, in the off-screen fingerprint recognition scheme, since a fingerprint recognition sensor is located under the display screen, light transmittance of the display screen at the fingerprint recognition region becomes a key indicator. In the off-screen fingerprinting scheme, too low transmittance cannot provide sufficient signals for an image acquisition and analysis system, thus preventing fast and reliable fingerprint recognition.

SUMMARY

In view of this, an aspect of the present disclosure provides a pixel array which is divided into at least one pixel distribution region. The pixel array comprises at least one standard pixel unit and at least one non-standard pixel unit distributed in the at least one pixel distribution region, wherein at least one sub-pixel is missing from the non-standard pixel unit compared to the standard pixel unit, and the at least one sub-pixel that is missing is replaced by a sub-pixel missing region.

According to some embodiments, the pixel array comprises a plurality of the pixel distribution regions, and in individual pixel distribution regions, the numbers of the non-standard pixel units are equal.

According to some embodiments, in each of the pixel distribution regions, n sub-pixels having the same color as each missing sub-pixel are present around the sub-pixel missing region, n being an integer not less than 1.

According to some embodiments, the n sub-pixels are configured to compensate for luminance loss of the sub-pixel missing region, and a theoretical luminance of each missing sub-pixel is assigned to the n sub-pixels.

According to some embodiments, n is an integer greater than 1, distances of the n sub-pixels from the sub-pixel missing region are substantially equal to one another, and the theoretical luminance of each missing sub-pixel is evenly assigned to the n sub-pixels.

According to some embodiments, the n sub-pixels are one sub-pixel of the same color as a missing sub-pixel in one standard pixel unit directly adjacent to the sub-pixel missing region.

According to some embodiments, the one standard pixel unit is located in a same row or a same column as a non-standard pixel unit in which the sub-pixel missing region is located.

According to some embodiments, a theoretical grayscale value of each missing sub-pixel, theoretical grayscale values of the n sub-pixels, and actual grayscale values of the n sub-pixels satisfy a relationship as follows:

$$I'_{Ci}{}^{\gamma}=I_{Ci}{}^{\gamma}+\frac{1}{n}*I_A{}^{\gamma} \ , \ i=1,2,\ldots,n$$

wherein, $I_A$ represents a theoretical grayscale value of each missing sub-pixel, $I_{Ci}$ represents a theoretical grayscale value of an i-th sub-pixel of the n sub-pixels, $I'_{Ci}$ represents an actual grayscale value of the i-th sub-pixel of the n sub-pixels, and $\gamma$ represents a constant.

According to some embodiments, each standard pixel unit comprises a first color sub-pixel, a second color sub-pixel, and a third color sub-pixel, and each non-standard pixel unit comprises a first color sub-pixel, a second color sub-pixel, and a sub-pixel missing region in place of a third color sub-pixel.

According to some embodiments, the at least one standard pixel unit comprises at least one first standard pixel unit and at least one second standard pixel unit, the at least one non-standard pixel unit comprises at least one first non-standard pixel unit and/or at least one second non-standard pixel unit. Each first standard pixel unit comprises a first color sub-pixel and a second color sub-pixel. Each second standard pixel unit comprises a second color sub-pixel and a third color sub-pixel. Each first non-standard pixel unit comprises a first color sub-pixel and a sub-pixel missing region in place of a second color sub-pixel or a second color sub-pixel and a sub-pixel missing region in place of a first color sub-pixel. Each second non-standard pixel unit comprises a second color sub-pixel and a sub-pixel missing region in place of a third color sub-pixel or a third color sub-pixel and a sub-pixel missing region in place of a second color sub-pixel.

According to some embodiments, the first color sub-pixel, the second color sub-pixel, and the third color sub-pixel of each standard pixel unit are arranged in a same row or a same column, and the first color sub-pixel, the second color sub-pixel, and the sub-pixel missing region in place of the third color sub-pixel of each non-standard pixel unit are arranged in a same row or a same column.

According to some embodiments, each standard pixel unit has a positional relationship with a first virtual triangle as follows: three vertices of the first virtual triangle are located within the first color sub-pixel, the second color sub-pixel, and the third color sub-pixel of the standard pixel unit, respectively, and each non-standard pixel unit has a positional relationship with a second virtual triangle as follows: three vertices of the second virtual triangle are located within the first color sub-pixel, the second color sub-pixel, and the sub-pixel missing region in place of the third color sub-pixel of the non-standard pixel unit, respectively.

According to some embodiments, the first color sub-pixel and the second color sub-pixel of each first standard pixel unit are disposed along a first direction, the second color sub-pixel and the third color sub-pixel of each second standard pixel unit are disposed along the first direction, the first color sub-pixel and the sub-pixel missing region or the second color sub-pixel and the sub-pixel missing region of each first non-standard pixel unit are disposed along the first direction, and the second color sub-pixel and the sub-pixel missing region or the third color sub-pixel and the sub-pixel missing region of each second non-standard pixel unit are disposed along the first direction, the first direction being parallel to neither of a row direction and a column direction of the pixel array.

According to some embodiments, the second color sub-pixel is a green sub-pixel.

According to some embodiments, in each non-standard pixel unit, the sub-pixel missing region replaces a second color sub-pixel, four second color sub-pixels adjacent to the sub-pixel missing region are configured to compensate for luminance loss of the sub-pixel missing region, and the four second color sub-pixels have a positional relationship with a virtual diamond as follows: four vertices of the virtual diamond are located within the four second color sub-pixels, respectively, and a center of the virtual diamond is located within the sub-pixel missing region.

Another aspect of the present disclosure provides a display device comprising any of the pixel arrays described above.

According to some embodiments, the above display device further comprises a fingerprint recognition region integrated under a display screen of the display device, wherein a projection of the sub-pixel missing region on a plane where the fingerprint recognition region resides at least partially overlaps the fingerprint recognition region.

A further aspect of the present disclosure provides a driving method of a pixel array, comprising: acquiring a theoretical grayscale value of each sub-pixel according to an image to be displayed; acquiring actual grayscale values of sub-pixels other than a replaced sub-pixel according to an algorithm and an acquired theoretical grayscale value of each sub-pixel; and driving each sub-pixel according to an acquired actual grayscale value of each sub-pixel. In each pixel distribution region, actual grayscale values of n sub-pixels having a same color as each replaced sub-pixel are configured to compensate for a theoretical grayscale value of each replaced sub-pixel, n being an integer not less than 1. According to some embodiments, n is an integer greater than 1, distances of the n sub-pixels from the sub-pixel missing region are substantially equal to one another, and the algorithm is:

$$I'_{Ci}{}^{\gamma}=I_{Ci}{}^{\gamma}+\frac{1}{n}*I_A{}^{\gamma} \ , \ \ i=1,2,\ldots,n$$

where, $I_A$ represents a theoretical grayscale value of each replaced sub-pixel, $I_{Ci}$ represents a theoretical grayscale value of an i-th sub-pixel of the n sub-pixels, $I'_{Ci}$ represents an actual grayscale value of the i-th sub-pixel of the n sub-pixels, and $\gamma$ represents a constant.

According to some embodiments, the sub-pixel missing region replaces a second color sub-pixel, four second color sub-pixels adjacent to the sub-pixel missing region are configured to compensate for luminance loss of the sub-pixel missing region, the four second color sub-pixels have a positional relationship with a virtual diamond as follows: four vertices of the virtual diamond are located within the four second color sub-pixels, respectively, and a center of the virtual diamond is located within the sub-pixel missing region, and the driving method further comprises: assigning to each of the four second color sub-pixels 25% of a theoretical luminance of a replaced second color sub-pixel.

According to some embodiments, the sub-pixel missing region replaces a first color sub-pixel, and the driving method further comprises: assigning a theoretical luminance of a replaced first color sub-pixel to one first color sub-pixel adjacent to the sub-pixel missing region.

According to some embodiments, the one first color sub-pixel is a first color sub-pixel in one standard pixel unit directly adjacent to the sub-pixel missing region.

According to some embodiments, the one standard pixel unit is located in a same row or in a same column as a non-standard pixel unit in which the sub-pixel missing region is located.

According to some embodiments, the sub-pixel missing region replaces a third color sub-pixel, and the driving method further comprises: assigning a theoretical luminance of a replaced third color sub-pixel to one third color sub-pixel adjacent to the sub-pixel missing region.

According to some embodiments, the one third color sub-pixel is a third color sub-pixel in one standard pixel unit directly adjacent to the sub-pixel missing region.

According to some embodiments, the one standard pixel unit is located in a same row or in a same column as a non-standard pixel unit in which the sub-pixel missing region is located.

It is to be understood that the above general description and the following detailed description are merely exemplary and illustrative, and are not intended to limit the present disclosure in any way.

BRIEF DESCRIPTION OF DRAWINGS

In order to more clearly illustrate the technical solutions in embodiments of the present disclosure, the accompanying drawings to be used for description of the embodiments will be briefly described below. It is to be noted that the dimensions shown in the drawings are merely schematic and are not intended to limit the present disclosure in any way.

Fig. 1 schematically illustrates a pixel array according to an embodiment of the present disclosure.

Fig. 2 schematically illustrates a pixel array according to another embodiment of the present disclosure.

Fig. 3 schematically illustrates a pixel array according to a further embodiment of the present disclosure.

Fig. 4 schematically illustrates a luminance compensation scheme according to an embodiment of the present disclosure.

Fig. 5 schematically illustrates a luminance compensation scheme according to another embodiment of the present disclosure.

Fig. 6 schematically illustrates a luminance compensation scheme according to a further embodiment of the present disclosure.

Fig. 7 schematically illustrates a flow chart of a driving method of a pixel array according to an embodiment of the present disclosure.

Embodiments of the present disclosure have been clearly illustrated by the above-described drawings, which will be described in more detail later. The drawings and literal descriptions are not intended to limit the scope of the present disclosure in any way, but to illustrate the concept of the present disclosure to those ordinarily skilled in the art by reference to specific embodiments.

DETAILED DESCRIPTION

To make the purpose, technical solutions and advantages of embodiments of the present disclosure clearer, the technical solutions of the embodiments of the present disclosure will be further described in detail below with reference to the accompanying drawings.

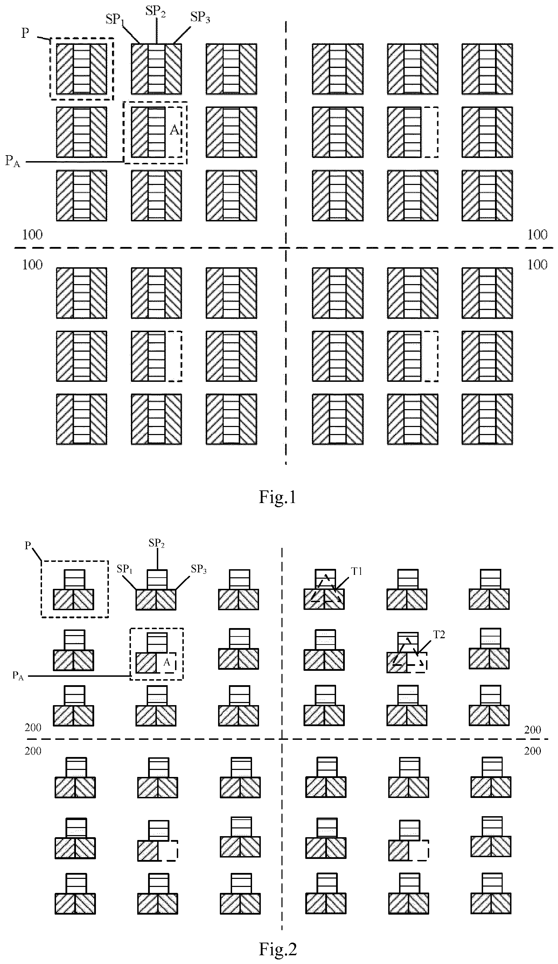

Fig. 1 schematically illustrates a pixel array according to an embodiment of the present disclosure. As shown in Fig. 1, the pixel array is divided into at least one pixel distribution region 100. The pixel array comprises at least one standard pixel unit P and at least one non-standard pixel unit $P_A$ distributed in the pixel distribution region 100. Each pixel unit P comprises sub-pixels $SP_1$, $SP_2$, and $SP_3$ of different colors. Compared to the standard pixel unit P, at least one sub-pixel $SP_{A3}$ is missing from the non-standard pixel unit $P_A$, and the missing sub-pixel $SP_{A3}$ is replaced by a sub-pixel missing region A.

As used herein, the term "sub-pixel missing region" refers to a region in which a sub-pixel should have been present in accordance with the arrangement of sub-pixels, but no sub-pixel is provided. In such a pixel array, by providing a sub-pixel missing region in the fingerprint recognition region, the light-shielding area of the pixel layer can be effectively reduced, which enhances the light transmittance of a display device comprising the pixel array so as to realize fast and reliable fingerprint recognition.

It is to be noted that although each pixel distribution region 100 is illustrated in Fig. 1 as comprising equal numbers of standard pixel units P and non-standard pixel units $P_A$, in other embodiments of the present disclosure, each pixel distribution region may comprise different numbers of standard pixel units and non-standard pixel units, as long as each pixel distribution region comprises a sub-pixel missing region. It is to be further noted that although only one sub-pixel $SP_{A3}$ of the non-standard pixel unit $P_A$ is replaced by the sub-pixel missing region A in Fig. 1, in other embodiments of the present disclosure, other sub-pixels, two sub-pixels or even all sub-pixels of the non-standard pixel unit $P_A$ may be replaced by sub-pixel missing regions. Optionally, as shown in Fig. 1, in each pixel distribution region 100, each standard pixel unit P comprises a first color sub-pixel $SP_1$, a second color sub-pixel $SP_2$, and a third color sub-pixel $SP_3$, and the non-standard pixel unit $P_A$ comprises a first color sub-pixel $SP_1$, a second color sub-pixel $SP_2$, and a sub-pixel missing region A in place of a third color sub-pixel $SP_3$.

In such an embodiment, the pixel array may adopt a typical RGB color scheme, wherein each standard pixel unit P comprises a red (R) sub-pixel, a green (G) sub-pixel, and a blue (B) sub-pixel, and a certain color (for example, green) sub-pixel in the non-standard pixel unit $P_A$ is replaced by a sub-pixel missing region A. Of course, as will be appreciated by those skilled in the art, other color schemes such as an RGBW color scheme may also be employed by the pixel array according to the present disclosure.

Optionally, as shown in Fig. 1, the first color sub-pixel $SP_1$, the second color sub-pixel $SP_2$, and the third color sub-pixel $SP_3$ of each standard pixel unit P are arranged in the same row, and the first color sub-pixel $SP_1$, the second color sub-pixel $SP_2$, and the sub-pixel missing region A of each non-standard pixel unit $P_A$ are arranged in the same row. Alternatively, in other embodiments of the present disclosure, the first color sub-pixel $SP_1$, the second color sub-pixel $SP_2$, and the third color sub-pixel $SP_3$ of each standard pixel unit P are arranged in the same column, and the first color sub-pixel $SP_1$, the second color sub-pixel $SP_2$, and the sub-pixel missing region A of each non-standard pixel unit $P_A$ are arranged in the same column.

Fig. 2 schematically illustrates a pixel array according to another embodiment of the present disclosure. As shown in Fig. 2, the pixel array is divided into a plurality of pixel distribution regions 200. The pixel array comprises a plurality of standard pixel units P and at least one non-standard pixel unit $P_A$ distributed in the pixel distribution regions. In each of the pixel distribution regions 200, each of the standard pixel units P comprises sub-pixels $SP_1$, $SP_2$, and $SP_3$ of different colors. Compared to the standard pixel unit P, one sub-pixel $SP_{A3}$ is missing from the non-standard pixel unit $P_A$, and the missing sub-pixel $SP_{A3}$ is replaced by a sub-pixel missing region A.

It is also to be noted that although each pixel distribution region 200 is illustrated in Fig. 2 as comprising equal numbers of standard pixel units P and non-standard pixel units $P_A$, in other embodiments of the present disclosure, each pixel distribution region may have different numbers of standard pixel units and non-standard pixel units, as long as each pixel distribution region comprises a sub-pixel missing region. It is to be further noted that although only one sub-pixel $SP_{A3}$ of the non-standard pixel unit $P_A$ is replaced by the sub-pixel missing region A in Fig. 2, in other embodiments of the present disclosure, other sub-pixels, two sub-pixels or even all sub-pixels of the non-standard pixel unit $P_A$ may be replaced by sub-pixel missing regions.

Optionally, as shown in Fig. 2, in each pixel distribution region 200, each standard pixel unit P comprises a first color sub-pixel $SP_1$, a second color sub-pixel $SP_2$, and a third color sub-pixel $SP_3$, and each non-standard pixel unit $P_A$ comprises a first color sub-pixel $SP_1$, a second color sub-pixel $SP_2$, and a sub-pixel missing region A in place of a third color sub-pixel $SP_3$.

In such an embodiment, the pixel array may adopt a typical RGB color scheme, wherein each standard pixel unit comprises a red (R) sub-pixel, a green (G) sub-pixel, and a blue (B) sub-pixel, and a certain color (for example, green) sub-pixel in each non-standard pixel unit is replaced by a sub-pixel missing region. Of course, as will be appreciated by those skilled in the art, other color schemes such as an RGBW color scheme may also be employed by the pixel array according to the present disclosure.

Unlike the pixel array shown in Fig. 1, in the pixel array shown in Fig. 2, each of the standard pixel units P has the following positional relationship with a first virtual triangle T1: three vertices of the first virtual triangle T1 are located within the first color sub-pixel $SP_1$, the second color sub-pixel $SP_2$, and the third color sub-pixel $SP_3$ of the standard pixel unit P, respectively, and each non-standard pixel unit $P_A$ has the following positional relationship with a second virtual triangle T2: three vertices of the second virtual triangle T2 are located within the first color sub-pixel $SP_1$, the second color sub-pixel $SP_2$, and the sub-pixel missing region A of the non-standard pixel unit $P_A$, respectively.

As will be readily understood by those skilled in the art, although sub-pixels are illustrated in Figs. 1 and 2 as having a rectangular shape, this is merely illustrative, and the present disclosure is not limited thereto. In practical applications, sub-pixels may have other shapes as needed.

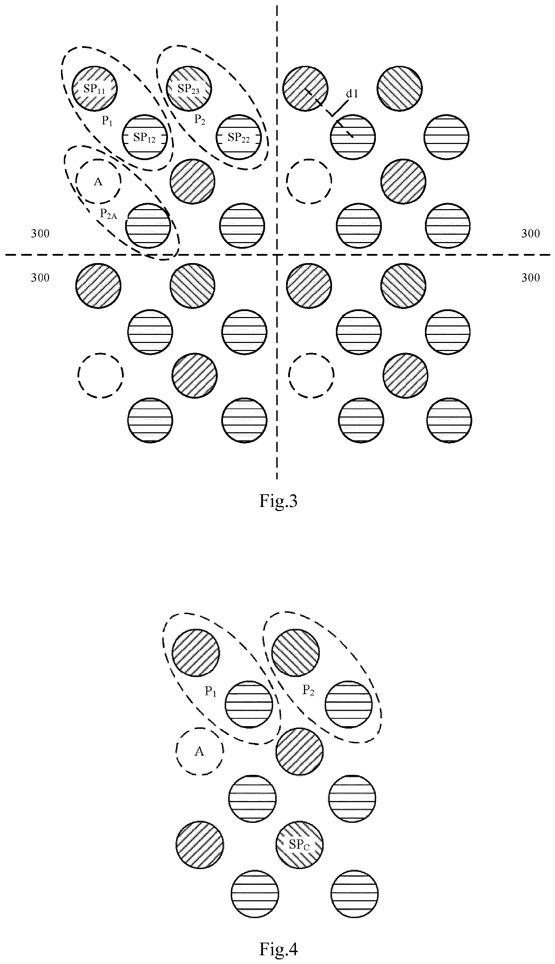

Fig. 3 schematically illustrates a pixel array according to a further embodiment of the present disclosure. As shown in Fig. 3, the pixel array is divided into at least one pixel distribution region 300. The pixel array comprises a plurality of standard pixel units and at least one non-standard pixel unit distributed in the pixel distribution region 300. The plurality of standard pixel units comprise at least one first standard pixel unit $P_1$ and at least one second standard pixel unit $P_2$. The at least one non-standard pixel unit comprises at least one first non-standard pixel unit and/or at least one second non-standard pixel unit. Compared to the first standard pixel unit $P_1$, at least one sub-pixel is missing from the first non-standard pixel unit, and the missing sub-pixel is replaced by a sub-pixel missing region A. Compared to the second standard pixel unit $P_2$, at least one sub-pixel is missing from the second non-standard pixel unit, and the missing sub-pixel is replaced by a sub-pixel missing region A. In a general case where there is no sub-pixel missing region, the first standard pixel unit $P_1$ and the second standard pixel unit $P_2$ are alternately arranged in the row direction and the column direction of the pixel array. In each pixel distribution region 300, each first standard pixel unit $P_1$ comprises a first color sub-pixel $SP_{11}$ and a second color sub-pixel $SP_{12}$, and each second standard pixel unit $P_2$ comprises a second color sub-pixel $SP_{22}$ and a third color sub-pixel $SP_{23}$. The second non-standard pixel unit $P_{2A}$ comprises a second color sub-pixel $SP_{22}$ and a sub-pixel missing region A in place of a third color sub-pixel $SP_{23}$. Alternatively, in other embodiments (not shown) of the present disclosure, the second non-standard pixel unit $P_{2A}$ may comprise a third color sub-pixel $SP_{23}$ and a sub-pixel missing region A in place of a second color sub-pixel $SP_{22}$.

It is to be noted that, although Fig. 3 illustrates the implementation of this embodiment based on an example in which the non-standard pixel unit only comprises the second non-standard pixel unit $P_{2A}$, in other embodiments of the present disclosure, the non-standard pixel unit may comprise only the first non-standard pixel unit, or both the first non-standard pixel unit and the second non-standard pixel unit, and the sub-pixel missing region may replace any one or more sub-pixels in the first non-standard pixel unit and/or the second non-standard pixel unit.

In such an embodiment, the pixel array may be in a Pentile arrangement. The Pentile arrangement is a technology that emerged with the birth of OLED display materials. Unlike a typical RGB color scheme, in a typical Pentile arrangement, each pixel unit only consists of sub-pixels of two colors, for example, one pixel unit includes only an R sub-pixel and a G sub-pixel, and another pixel unit includes only a B sub-pixel and a G sub-pixel. Since all colors can be obtained only when the R, G and B primary colors are available, when an image is actually displayed, each pixel unit shares a sub-pixel of a certain color that it does not have with adjacent pixel units in the row direction or the column direction of the pixel array, thereby achieving color display. The concept of the present disclosure is equally applicable to the Pentile arrangement. It is to be noted that, in the case of not taking the sub-pixel missing region into account, in the Pentile arrangement described above, each pixel unit comprises a second color sub-pixel, that is, the resolution of the second color sub-pixel is the same as the resolution of a display device comprising the pixel array, and the numbers of the first color sub-pixels and the third color sub-pixels of the display device are halved.

Optionally, as shown in Fig. 3, the first color sub-pixel $SP_{11}$ and the second color sub-pixel $SP_{12}$ of each first standard pixel unit $P_1$ are arranged along a first direction d1, the second color sub-pixel $SP_{22}$ and the third color sub-pixel $SP_{23}$ of each second standard pixel unit $P_2$ are arranged along the first direction d1, and the second color sub-pixel $SP_{22}$ and the sub-pixel missing region A of the second non-standard pixel unit $P_{2A}$ are arranged along the first direction d1. As shown in Fig. 3, the first direction d1 is parallel to neither of the row direction and the column direction of the pixel array.

As will be readily understood by those skilled in the art, although sub-pixels are illustrated in Fig. 3 as having a circular shape, this is merely illustrative, and the present disclosure is not limited thereto. In practical applications, sub-pixels may have other shapes as needed.

In some embodiments of the present disclosure, the second color sub-pixels $SP_{12}$ and $SP_{22}$ are green sub-pixels. Since human eyes are most sensitive to the green color, by making the resolution of the green sub-pixel the same as the resolution of the display device while the numbers of sub-pixels of other colors are halved, it is possible to improve the display effect of the display device while increasing the resolution of the display device.

In the pixel arrays as shown in Figs. 1-3, optionally, in each pixel distribution region, n sub-pixels adjacent to the sub-pixel missing region and having the same color as the replaced sub-pixel are configured to compensate for luminance loss of the sub-pixel missing region, and n is an integer not less than 1.

In the pixel array according to the present disclosure, due to the presence of a sub-pixel missing region, a pixel unit comprising the sub-pixel missing region will undergo color shift, which in turn affects the display effect of a display device comprising the pixel array. Therefore, n sub-pixels of the same color adjacent to the sub-pixel replaced by the sub-pixel missing region can compensate for the luminance of the replaced sub-pixel, thereby ensuring a normal display effect of the display device.

For example, as shown in Fig. 4, taking the pixel array as shown in Fig. 3 as an example, the sub-pixel missing region A replaces the third color sub-pixel of the second non-standard pixel unit, and the luminance of a third color sub-pixel $SP_C$ which is located at the lower right relative to the sub-pixel missing region A is raised with respect to its theoretical luminance to compensate for luminance loss of the sub-pixel missing region A.

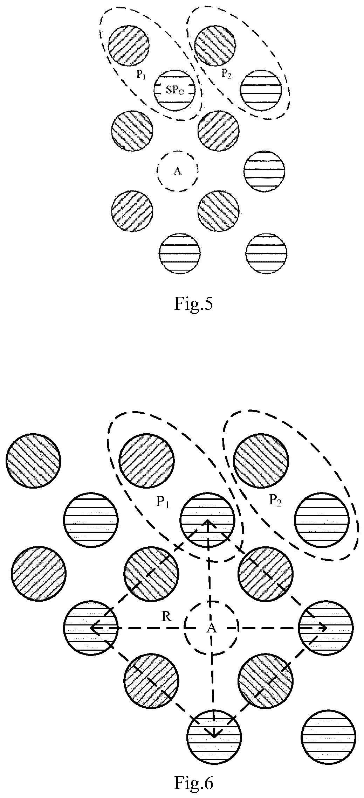

Alternatively, as shown in Fig. 5, the sub-pixel missing region A may replace the second color sub-pixel of the second non-standard pixel unit $P_2$, and the luminance of the second color sub-pixel $SP_C$ above the sub-pixel missing region A is raised with respect to its theoretical luminance to compensate for luminance loss of the sub-pixel missing region A.

It is to be noted that in other embodiments of the present disclosure, a sub-pixel of the same color which is configured to compensate for the luminance of the replaced sub-pixel may also be located at other positions relative to the sub-pixel missing region, without being limited to the lower right and the upper position as shown in Figs. 4 and 5, as long as the compensation sub-pixel is adjacent to the replaced sub-pixel of the same color. For example, one sub-pixel having the same color as the missing sub-pixel in one standard pixel unit directly adjacent to the sub-pixel missing region may be configured to compensate for the luminance of the replaced sub-pixel. For example, the standard pixel unit and the non-standard pixel unit in which the sub-pixel missing region is located may be in the same row or in the same column.

In the case where n is greater than 1, the n sub-pixels may be substantially equal in distance from the sub-pixel missing region, and the theoretical luminance of each missing sub-pixel is evenly assigned to the n sub-pixels. Alternatively, the n sub-pixels may be unequal in distance from the sub-pixel missing region, and the proportion of luminance assigned to a sub-pixel farther from the sub-pixel missing region is smaller.

As used herein, the term "substantially" may mean that the deviation between the actual value and the standard value is within a predetermined range, which may be 20%, or less than 20%, for example, 10%, 5%, 1%, or the like.

Fig. 6 schematically illustrates a luminance compensation scheme according to a further embodiment of the present disclosure. As shown in Fig. 6, the pixel array shown in Fig. 3 is also taken as an example, but the sub-pixel missing region A replaces the second color sub-pixel $SP_{22}$ of the second non-standard pixel unit $P_2$. Four second color sub-pixels $SP_{12}$ adjacent to the sub-pixel missing region A are configured to compensate for luminance loss of the sub-pixel missing region A, wherein the second color sub-pixels $SP_{12}$ have the following positional relationship with a virtual diamond R: four vertices of the virtual diamond R are located within the four second color sub-pixels $SP_{12}$, respectively, and the center of the virtual diamond R is located in the sub-pixel missing region A.

As used herein, the term "center" is not limited to a single point, but may relate to a region radiating a specific distance outwards from the centroid point of the virtual diamond R. The specific distance may be 1/3 of the distance from the centroid point of the virtual diamond R to its boundary.

In such an embodiment, the theoretical luminance of the second color sub-pixel replaced by the sub-pixel missing region is assigned to four second color sub-pixels adjacent thereto, and the four second color sub-pixels are evenly distributed with respect to the second color sub-pixel, so that uniform compensation of the lost luminance can be achieved, thereby achieving a good display effect.

In some embodiments of the present disclosure, the theoretical luminance of each missing sub-pixel is evenly assigned to n sub-pixels that are substantially equal in distance therefrom.

As used herein, the term "theoretical luminance" refers to the luminance of a sub-pixel acquired according to an image to be displayed, which is relative to the term "actual luminance". The term "actual luminance" refers to the luminance of a sub-pixel after compensating for the theoretical luminance of the replaced sub-pixel. In such an embodiment, the actual luminance of each of the n sub-pixels will be the sum of its theoretical luminance and 1/n of the theoretical luminance of the replaced sub-pixel.

Specifically, the theoretical grayscale value of each missing sub-pixel, the theoretical grayscale values of the n sub-pixels, and the actual grayscale values of the n sub-pixels may satisfy the following relationship:

$$I'_{Ci}{}^{\gamma} = I_{Ci}{}^{\gamma} + \frac{1}{n} * I_A{}^{\gamma} \;,\; i = 1, 2, \ldots, n$$

wherein, $I_A$ represents the theoretical grayscale value of each missing sub-pixel, $I_{Ci}$ represents the theoretical grayscale value of an i-th sub-pixel of the n sub-pixels, $I'_{Ci}$ represents the actual grayscale value of the i-th sub-pixel of the n sub-pixels, and $\gamma$ represents a constant.

As is known to those skilled in the art, for a particular display device, the luminance value of each sub-pixel has a linear relation with the $\gamma$ power of the grayscale value of the sub-pixel, where $\gamma$ is a constant. Corresponding to the theoretical luminance and the actual luminance respectively, the term "theoretical grayscale value" refers to the grayscale value of a sub-pixel acquired according to an image to be displayed, and the term "actual grayscale value" refers to the grayscale value of a sub-pixel after compensating for the theoretical luminance of the replaced sub-pixel. As can be seen from the above formula, the luminance of a sub-pixel replaced by a sub-pixel missing region is evenly assigned to the n sub-pixels, thereby achieving more uniform luminance compensation to achieve a good display effect.

An embodiment of the present disclosure further provides a display device comprising any of the pixel arrays described above.

In such a display device, by providing a sub-pixel missing region in the fingerprint recognition region, the light-shielding area of the pixel layer can be effectively reduced, which enhances the light transmittance of the display device, so as to realize fast and reliable fingerprint recognition.

In some embodiments of the present disclosure, the above display device further comprises a fingerprint recognition region integrated under the display screen of the display device. The projection of the sub-pixel missing region on the plane where the fingerprint recognition region resides at least partially overlaps the fingerprint recognition region.

The above display device may be applied to any system having a display function, including a desktop computer, a laptop computer, a television, a mobile phone, a tablet computer, and the like. In particular, the above display device may be an OLED display device.

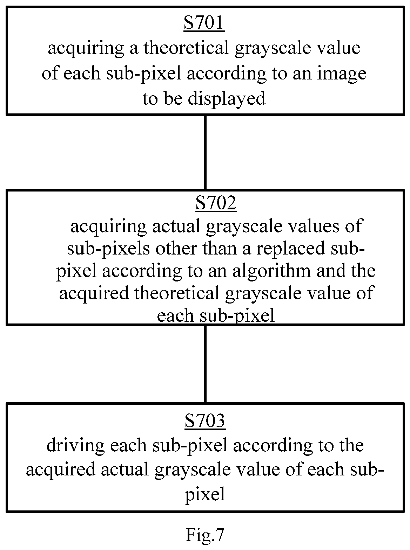

An embodiment of the present disclosure further provides a driving method of any of the pixel arrays described above. As shown in Fig. 7, at step S701, a theoretical grayscale value of each sub-pixel is acquired according to an image to be displayed. Next, at step S702, actual grayscale values of sub-pixels other than the replaced sub-pixel are acquired according to an algorithm and the acquired theoretical grayscale value of each sub-pixel. Then, at step S703, each sub-pixel is driven according to the acquired actual grayscale value of each sub-pixel. In particular, the actual grayscale values of the n sub-pixels having the same color as each replaced sub-pixel are configured to compensate for the theoretical grayscale value of each replaced sub-pixel, n being an integer not less than 1.

In some embodiments of the present disclosure, n is an integer greater than 1, the distances of the n sub-pixels from the sub-pixel missing region are substantially equal to one another, and the algorithm is:

$$I'_{Ci}{}^{\gamma}=I_{Ci}{}^{\gamma}+\frac{1}{n}*I_A{}^{\gamma}, \quad i=1,2,\ldots,n$$

wherein, $I_A$ represents the theoretical grayscale value of each replaced sub-pixel, $I_{Ci}$ represents the theoretical grayscale value of an i-th sub-pixel of the n sub-pixels, $I'_{Ci}$ represents the actual grayscale value of the i-th sub-pixel of the n sub-pixels, and $\gamma$ represents a constant.

In the driving method of a pixel array according to the present disclosure, by acquiring the actual grayscale value of each sub-pixel according to an algorithm and the theoretical grayscale value of each sub-pixel, n sub-pixels of the same color adjacent to the sub-pixel replaced by the sub-pixel missing region can compensate for the luminance of the replaced sub-pixel, thereby avoiding the color shift of the display device and ensuring a normal display effect of the display device.

In some embodiments of the present disclosure, the theoretical luminance of each replaced sub-pixel is evenly assigned to the n sub-pixels.

In some embodiments of the present disclosure, the sub-pixel missing region replaces the second color sub-pixel, and four second color sub-pixels adjacent to the sub-pixel missing region are configured to compensate for luminance loss of the sub-pixel missing region. The four second color sub-pixels have the following positional relationship with a virtual diamond: four vertices of the virtual diamond are located within the four second color sub-pixels, respectively, and the center of the virtual diamond is located within the sub-pixel missing region. In this case, the above driving method further comprises: assigning to each of the four second color sub-pixels 25% of the theoretical luminance of the replaced second color sub-pixel.

In some embodiments of the present disclosure, the sub-pixel missing region replaces the first color sub-pixel. In this case, the driving method further comprises: assigning the theoretical luminance of the replaced first color sub-pixel to one first color sub-pixel adjacent to the sub-pixel missing region.

In some embodiments of the present disclosure, the sub-pixel missing region replaces the third color sub-pixel. In this case, the driving method further comprises: assigning the theoretical luminance of the replaced third color sub-pixel to one third color sub-pixel adjacent to the sub-pixel missing region.

Unless otherwise defined, technical terms or scientific terms used in the present disclosure should have common meanings understood by a person of ordinary skill in the field to which the present disclosure pertains. The words such as "first", "second", and the like used in the present disclosure do not denote any order, quantity, or importance, but are used to distinguish different components. Similarly, the words such as "a", "an", "the" and the like do not indicate limitation in number, but mean the presence of at least one. The word such as "comprising", "including" or the like mean that an element or item preceding the word encompasses elements or items and equivalents thereof listed after said word, but do not exclude other elements or items. The words such as "connected", "linked" and the like are not limited to physical or mechanical connections, but may include electrical connections, regardless of being direct or indirect. "Upper", "lower", "left", "right", or the like is only used to indicate a relative positional relationship, and when the absolute position of the described object is changed, the relative positional relationship may also change accordingly. It is to be noted that the features in the above-described embodiments may be used in any combination in case of causing no conflict.

What have been stated above are merely specific embodiments of the present disclosure, but the scope of the present disclosure is not so limited. Any variations or substitutions that can be easily conceived by those ordinarily skilled in the art within the technical scope revealed by the present disclosure should be encompassed in the scope of the present disclosure. Therefore, the scope of the present disclosure should be determined by the scope of the claims.

## Claims

1. A pixel array, the pixel array being divided into at least one pixel distribution region, the pixel array comprising at least one standard pixel unit and at least one non-standard pixel unit distributed in the at least one pixel distribution region, wherein at least one sub-pixel is missing from the non-standard pixel unit compared to the standard pixel unit, and a region to which the at least one sub-pixel that is missing corresponds is a sub-pixel missing region.

2. The pixel array according to claim 1, wherein the pixel array comprises a plurality of the pixel distribution regions, and in individual pixel distribution regions, the numbers of the non-standard pixel units are equal.

3. The pixel array according to claim 1, wherein in each of the pixel distribution regions, n sub-pixels having the same color as each missing sub-pixel are present around the sub-pixel missing region, n being an integer not less than 1.

4. The pixel array according to claim 3, wherein the n sub-pixels are configured to compensate for luminance loss of the sub-pixel missing region, and a theoretical luminance of each missing sub-pixel is assigned to the n sub-pixels.

5. The pixel array according to claim 4, wherein n is an integer greater than 1, distances of the n sub-pixels from the sub-pixel missing region are substantially equal to one another, and the theoretical luminance of each missing sub-pixel is evenly assigned to the n sub-pixels.

6. The pixel array according to claim 4,wherein the n sub-pixels are one sub-pixel of the same color as a missing sub-pixel in one standard pixel unit directly adjacent to the sub-pixel missing region.

7. The pixel array according to claim 6, wherein the one standard pixel unit is located in a same row or a same column as a non-standard pixel unit in which the sub-pixel missing region is located.

8. The pixel array according to any one of claims 5 to 7,wherein a theoretical grayscale value of each missing sub-pixel, theoretical grayscale values of the n sub-pixels, and actual grayscale values of the n sub-pixels satisfy a relationship as follows:

$$I'_{Ci}{}^{\gamma} = I_{Ci}{}^{\gamma} + \frac{1}{n} * I_A{}^{\gamma} \ , \ i = 1, 2, \ldots, n$$

wherein, $I_A$ represents a theoretical grayscale value of each missing sub-pixel, $I_{Ci}$ represents a theoretical grayscale value of an i-th sub-pixel of the n sub-pixels, $I'_{Ci}$ represents an actual grayscale value of the i-th sub-pixel of the n sub-pixels, and $\gamma$ represents a constant.

9. The pixel array according to claim 1, wherein each standard pixel unit comprises a first color sub-pixel, a second color sub-pixel, and a third color sub-pixel, and each non-standard pixel unit comprises a first color sub-pixel, a second color sub-pixel, and a sub-pixel missing region in place of a third color sub-pixel.

10. The pixel array according to claim 1, wherein
    the at least one standard pixel unit comprises at least one first standard pixel unit and at least one second standard pixel unit, the at least one non-standard pixel unit comprises at least one first non-standard pixel unit and/or at least one second non-standard pixel unit;
    each first standard pixel unit comprising a first color sub-pixel and a second color sub-pixel;
    each second standard pixel unit comprising a second color sub-pixel and a third color sub-pixel;
    each first non-standard pixel unit comprising a first color sub-pixel and a sub-pixel missing region in place of a second color sub-pixel or a second color sub-pixel and a sub-pixel missing region in place of a first color sub-pixel;
    each second non-standard pixel unit comprising a second color sub-pixel and a sub-pixel missing region in place of a third color sub-pixel or a third color sub-pixel and a sub-pixel missing region in place of a second color sub-pixel.

11. The pixel array according to claim 9, wherein the first color sub-pixel, the second color sub-pixel, and the third color sub-pixel of each standard pixel unit are arranged in a same row or a same column, and the first color sub-pixel, the second color sub-pixel, and the sub-pixel missing region in place of the third color sub-pixel of each non-standard pixel unit are arranged in a same row or a same column.

12. The pixel array according to claim 9, wherein each standard pixel unit has a positional relationship with a first virtual triangle as follows: three vertices of the first virtual triangle are located within the first color sub-pixel, the second color sub-pixel, and the third color sub-pixel of the standard pixel unit, respectively, and each non-standard pixel unit has a positional relationship with a second virtual triangle as follows: three vertices of the second virtual triangle are located within the first color sub-pixel, the second color sub-pixel, and the sub-pixel missing region in place of the third color sub-pixel of the non-standard pixel unit, respectively.

13. The pixel array according to claim 10, wherein the first color sub-pixel and the second color sub-pixel of each first standard pixel unit are disposed along a first direction, the second color sub-pixel and the third color sub-pixel of each second standard pixel unit are disposed along the first direction, the first color sub-pixel and the sub-pixel missing region or the second color sub-pixel and the sub-pixel missing region of each first non-standard pixel unit are disposed along the first direction, and the second color sub-pixel and the sub-pixel missing region or the third color sub-pixel and the sub-pixel missing region of each second non-standard pixel unit are disposed along the first direction, the first direction being parallel to neither of a row direction and a column direction of the pixel array.

14. The pixel array according to claim 13,wherein the second color sub-pixel is a green sub-pixel.

15. The pixel array according to claim 13, wherein in each non-standard pixel unit, the sub-pixel missing region replaces a second color sub-pixel, and four second color sub-pixels adjacent to the sub-pixel missing region are configured to compensate for luminance loss of the sub-pixel missing region, and the four second color sub-pixels have a positional relationship with a virtual diamond as follows: four vertices of the virtual diamond are located within the four second color sub-pixels, respectively, and a center of the virtual diamond is located within the sub-pixel missing region.

16. A display device comprising the pixel array according to any one of claims 1 to 15.

**17.** The display device according to claim 16, further comprising a fingerprint recognition region integrated under a display screen of the display device, wherein a projection of the sub-pixel missing region on a plane where the fingerprint recognition region resides at least partially overlaps the fingerprint recognition region.

**18.** A driving method of the pixel array according to claim 1, comprising:

acquiring a theoretical grayscale value of each sub-pixel according to an image to be displayed; acquiring actual grayscale values of sub-pixels other than a replaced sub-pixel according to an algorithm and an acquired theoretical grayscale value of each sub-pixel; and driving each sub-pixel according to an acquired actual grayscale value of each sub-pixel, wherein in each pixel distribution region, actual grayscale values of n sub-pixels having a same color as each replaced sub-pixel are configured to compensate for a theoretical grayscale value of each replaced sub-pixel, n being an integer not less than 1.

**19.** The driving method according to claim 18, wherein n is an integer greater than 1, distances of the n sub-pixels from the sub-pixel missing region are substantially equal to one another, and the algorithm is:

$$I'_{Ci}{}^{\gamma} = I_{Ci}{}^{\gamma} + \frac{1}{n} * I_A{}^{\gamma} \ , \ \ i = 1, 2, \ldots, n$$

where, $I_A$ represents a theoretical grayscale value of each replaced sub-pixel, $I_{Ci}$ represents a theoretical grayscale value of an i-th sub-pixel of the n sub-pixels, $I'_{Ci}$ represents an actual grayscale value of the i-th sub-pixel of the n sub-pixels, and $\gamma$ represents a constant.

**20.** The driving method according to claim 19, wherein the sub-pixel missing region replaces a second color sub-pixel, four second color sub-pixels adjacent to the sub-pixel missing region are configured to compensate for luminance loss of the sub-pixel missing region, the four second color sub-pixels have a positional relationship with a virtual diamond as follows: four vertices of the virtual diamond are located within the four second color sub-pixels, respectively, and a center of the virtual diamond is located within the sub-pixel missing region, and the driving method further comprises: assigning to each of the four second color sub-pixels 25% of a theoretical luminance of a replaced second color sub-pixel.

**21.** The driving method according to claim 18, wherein the sub-pixel missing region replaces a first color sub-pixel, and the driving method further comprises: assigning a theoretical luminance of a replaced first color sub-pixel to one first color sub-pixel adjacent to the sub-pixel missing region.

**22.** The driving method according to claim 21, wherein the one first color sub-pixel is a first color sub-pixel in one standard pixel unit directly adjacent to the sub-pixel missing region.

**23.** The driving method according to claim 22, wherein the one standard pixel unit is located in a same row or in a same column as a non-standard pixel unit in which the sub-pixel missing region is located.

**24.** The driving method according to claim 16, wherein the sub-pixel missing region replaces a third color sub-pixel, and the driving method further comprises: assigning a theoretical luminance of a replaced third color sub-pixel to one third color sub-pixel adjacent to the sub-pixel missing region.

**25.** The driving method according to claim 24, wherein the one third color sub-pixel is a third color sub-pixel in one standard pixel unit directly adjacent to the sub-pixel missing region.

**26.** The driving method according to claim 25, wherein the one standard pixel unit is located in a same row or in a same column as a non-standard pixel unit in which the sub-pixel missing region is located.

Fig.1

Fig.2

Fig.3

Fig.4

Fig.5

Fig.6

S701
acquiring a theoretical grayscale value
of each sub-pixel according to an image
to be displayed

S702
acquiring actual grayscale values of
sub-pixels other than a replaced sub-
pixel according to an algorithm and the
acquired theoretical grayscale value of
each sub-pixel

S703
driving each sub-pixel according to the
acquired actual grayscale value of each sub-
pixel

Fig.7

<table>
<tr><td colspan="2" align="center">**INTERNATIONAL SEARCH REPORT**</td><td colspan="2">International application No.<br><br>**PCT/CN2018/124149**</td></tr>
</table>

**A.    CLASSIFICATION OF SUBJECT MATTER**

G06K 9/00(2006.01)i

According to International Patent Classification (IPC) or to both national classification and IPC

**B.    FIELDS SEARCHED**

Minimum documentation searched (classification system followed by classification symbols)

G06K; G06F

Documentation searched other than minimum documentation to the extent that such documents are included in the fields searched

Electronic data base consulted during the international search (name of data base and, where practicable, search terms used)

CNPAT, CNKI, WPI, EPODOC: 指纹, 识别, 透光, 透明, 透射, 透过, 缺失, 缺少, 彩膜, 滤光, 滤色, 色阻, 像素, fingerprints, recogni+, transparen+, transm+, colo?r, filter, pixel?, subpixel

**C.    DOCUMENTS CONSIDERED TO BE RELEVANT**

| Category* | Citation of document, with indication, where appropriate, of the relevant passages | Relevant to claim No. |
|---|---|---|
| A | CN 105139793 A (BOE TECHNOLOGY GROUP CO., LTD. ET AL.) 09 December 2015 (2015-12-09)<br>  description, paragraphs [0039]-[0061], and figures 1-5 | 1-26 |
| A | CN 107798278 A (SHANGHAI OXI TECHNOLOGY CO., LTD.) 13 March 2018 (2018-03-13)<br>  entire document | 1-26 |
| A | CN 107452283 A (BOE TECHNOLOGY GROUP CO., LTD. ET AL.) 08 December 2017 (2017-12-08)<br>  entire document | 1-26 |
| A | CN 106773229 A (BOE TECHNOLOGY GROUP CO., LTD.) 31 May 2017 (2017-05-31)<br>  entire document | 1-26 |
| A | CN 106874892 A (LENOVO (BEIJING) CO., LTD.) 20 June 2017 (2017-06-20)<br>  entire document | 1-26 |
| A | CN 206193837 U (HUIZHOU TCL MOBILE COMMUNICATION CO., LTD.) 24 May 2017 (2017-05-24)<br>  entire document | 1-26 |

☑ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **07 March 2019** | **01 April 2019** |

| Name and mailing address of the ISA/CN | Authorized officer |
|---|---|
| **State Intellectual Property Office of the P. R. China**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2018/124149**

### C.    DOCUMENTS CONSIDERED TO BE RELEVANT

| Category* | Citation of document, with indication, where appropriate, of the relevant passages | Relevant to claim No. |
|---|---|---|
| A | CN 106873063 A (BOE TECHNOLOGY GROUP CO., LTD.) 20 June 2017 (2017-06-20) entire document | 1-26 |
| A | US 2018089491 A1 (SAMSUNG DISPLAY CO., LTD.) 29 March 2018 (2018-03-29) entire document | 1-26 |
| A | KR 20160056388 A (LG DISPLAY CO., LTD.) 20 May 2016 (2016-05-20) entire document | 1-26 |

Form PCT/ISA/210 (second sheet) (January 2015)

# EP 3 779 767 A1

<table>
<tr><td colspan="4" align="center">INTERNATIONAL SEARCH REPORT<br>Information on patent family members</td><td colspan="2">International application No.<br><br>**PCT/CN2018/124149**</td></tr>
<tr><td colspan="2" align="center">Patent document<br>cited in search report</td><td align="center">Publication date<br>(day/month/year)</td><td colspan="2" align="center">Patent family member(s)</td><td align="center">Publication date<br>(day/month/year)</td></tr>
<tr><td>CN</td><td>105139793　A</td><td>09 December 2015</td><td>US<br>WO</td><td>2017371213　A1<br>2017036078　A1</td><td>28 December 2017<br>09 March 2017</td></tr>
<tr><td>CN</td><td>107798278　A</td><td>13 March 2018</td><td colspan="2" align="center">None</td><td></td></tr>
<tr><td>CN</td><td>107452283　A</td><td>08 December 2017</td><td>US</td><td>20190042036　A1</td><td>07 February 2019</td></tr>
<tr><td>CN</td><td>106773229　A</td><td>31 May 2017</td><td>CN<br>WO</td><td>106773229　B<br>2018161541　A1</td><td>09 November 2018<br>13 September 2018</td></tr>
<tr><td>CN</td><td>106874892　A</td><td>20 June 2017</td><td>US</td><td>2018276445　A1</td><td>27 September 2018</td></tr>
<tr><td>CN</td><td>206193837　U</td><td>24 May 2017</td><td colspan="2" align="center">None</td><td></td></tr>
<tr><td>CN</td><td>106873063　A</td><td>20 June 2017</td><td>WO<br>CN<br>US</td><td>2018153065　A1<br>106873063　B<br>2018239455　A1</td><td>30 August 2018<br>18 September 2018<br>23 August 2018</td></tr>
<tr><td>US</td><td>2018089491　A1</td><td>29 March 2018</td><td>CN<br>EP<br>KR</td><td>107871447　A<br>3306526　A2<br>20180034750　A</td><td>03 April 2018<br>11 April 2018<br>05 April 2018</td></tr>
<tr><td>KR</td><td>20160056388　A</td><td>20 May 2016</td><td colspan="2" align="center">None</td><td></td></tr>
</table>

Form PCT/ISA/210 (patent family annex) (January 2015)

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201810288463